# FASCICULE DE BREVET EUROPEEN

(11) **EP 2 980 591 B1**
(45) Date de publication et mention de la délivrance du brevet: **01.04.2020**
(21) Numéro de dépôt: 15177411.4
(22) Date de dépôt: 17.07.2015
(51) Int. Cl.: G01R 11/24, G01R 22/06

(54) **COMPTEUR DE TYPE COMPTEUR ÉLECTRIQUE**
ZÄHLER VOM TYP STROMZÄHLER
METER SUCH AS AN ELECTRIC METER

(30) Priorité: 30.07.2014 FR 1457400
(43) Date de publication de la demande: 03.02.2016
(73) Titulaire: SAGEMCOM ENERGY & TELECOM SAS, 92500 Rueil-Malmaison (FR)
(72) Inventeur: Teboulle, Henri, 92500 Rueil Malmaison (FR); Rolland, Patrick, 92500 Rueil Malmaison (FR); Grincourt, Christophe, 92500 Rueil Malmaison (FR)
(74) Mandataire: Lavialle, Bruno François Stéphane

(56) Documents cités:
- WO-A2-03/065055
- FR-A1- 2 513 767
- FR-A1- 2 626 079
- FR-A1- 2 701 122
- US-A- 4 542 337

## Description

L'invention concerne un compteur de type compteur électrique comportant un témoin destiné à révéler qu'une tentative de fraude magnétique a été réalisée.

### ARRIERE PLAN DE L'INVENTION

Les compteurs électriques modernes sont des compteurs électroniques qui sont bien sûr adaptés à mesurer une quantité d'énergie électrique consommée dans une habitation ou dans un lieu quelconque et à afficher cette mesure, mais qui sont aussi capables de réaliser un certain nombre de fonctions complémentaires : gestion des tarifs par réception d'ordres, relève et programmation à distance, télé-information client, etc.

Les compteurs électroniques comportent au moins une carte électronique comprenant un certain nombre de composants électroniques. Ces composants électroniques sont, pour certains, destinés à réaliser les fonctions évoquées plus tôt, et pour d'autres, utilisés pour gérer le fonctionnement de la carte électronique : composants d'alimentation, de protection contre des surtensions ou des perturbations électromagnétiques, etc.

Certains abonnés tentent frauduleusement de perturber le fonctionnement de leur compteur électronique en utilisant de puissants aimants de manière à fausser la mesure de l'énergie électrique, à couper de manière intermittente ou continue l'alimentation de la carte électronique, ou à empêcher le compteur électronique de communiquer au fournisseur d'énergie électrique des informations sur la consommation d'énergie. Cette pratique bénéficie du développement de la commercialisation d'aimants de taille relativement réduite capables de générer un champs magnétique très important, tels que les aimants en néodyme. Ces aimants agissent principalement sur des composants inductifs de la carte électronique, par exemple sur des transformateurs utilisés pour la mesure de l'énergie électrique consommée, sur des transformateurs utilisés dans une alimentation de la carte, sur des transformateurs utilisés dans des interfaces de communication (typiquement des interfaces Courants Porteurs en Ligne, ou CPL), sur des inductances diverses, etc. Le champ magnétique généré par l'aimant sature les bobines des composants inductifs dont la valeur inductive s'effondre et dont le comportement électrique s'apparente alors à celui d'un fil (court-circuit).

Il est primordial pour le fournisseur d'énergie électrique que le compteur électronique soit capable de détecter une telle tentative de fraude et de remonter une alarme vers un central de surveillance du fournisseur d'énergie électrique. On munit ainsi classiquement un compteur électrique d'un capteur magnétique, par exemple d'un capteur à effet Hall, qui mesure le champ magnétique au niveau du compteur. Des moyens de traitement du compteur génèrent une alarme lorsque le champ magnétique mesuré par le capteur magnétique est supérieure à un seuil prédéterminé.

Il est en outre fondamental pour le fournisseur d'énergie électrique d'être en mesure de prouver irréfutablement qu'une telle tentative de fraude a eu lieu, pour pouvoir agir contre l'abonné coupable de la tentative de fraude. Or, la simple prise en compte de la mesure de champ magnétique fournie par le capteur magnétique ne fournit pas un élément de preuve irréfutable pour au moins deux raisons. La première raison est liée aux taux de panne et de détection intempestive associés aux composants compris dans la chaîne de mesure (incluant le capteur) qui ne permettent pas de considérer la mesure comme suffisamment fiable pour constituer un élément de preuve irréfutable, à moins bien sûr de développer une chaîne de mesure complexe et donc coûteuse (redondances, etc.). La seconde raison est liée au fait que certains aimants particulièrement puissants peuvent générer un champ magnétique suffisamment fort pour endommager irrémédiablement un composant et empêcher ainsi toute mesure de champ ou transmission d'alarme.

Le document WO 03/065055 A2 divulgue un compteur comprenant une bande ferromagnétique qui se courbe sous l'influence d'un champ magnétique externe et déplace de manière irréversible un indicateur.

### OBJET DE L'INVENTION

L'invention a pour objet de fournir un élément de preuve irréfutable destiné à prouver qu'une tentative de fraude par aimant a eu lieu visant à perturber le fonctionnement d'un compteur tel qu'un compteur électrique.

### RESUME DE L'INVENTION

En vue de la réalisation de ce but, on propose un compteur selon la revendication 1.

Ainsi, une tentative de fraude par aimant provoque un déplacement « mécanique » irréversible du témoin. Le témoin ne peut donc pas être replacé dans la position prédéterminée sous l'action de l'aimant ou sous une quelconque action réalisée à l'extérieur du boîtier du compteur. Comme les compteurs sont généralement scellés et/ou bouterollés selon la partie mécanique concernée (couvre-borne scellé et coffret bouterollé), l'individu coupable de la tentative de fraude ne peut ouvrir le compteur sans que cette ouverture ne soit détectable. Le déplacement du témoin constitue donc une preuve irréfutable de la tentative de fraude.

L'invention sera mieux comprise à la lumière de la description qui suit de modes de mise en œuvre particuliers non limitatifs de l'invention.

### BREVE DESCRIPTION DES DESSINS

Il sera fait référence aux dessins annexés, parmi lesquels :
- la figure 1 est une vue en perspective du compteur de l'invention ;
- la figure 2 est une vue en perspective du témoin du compteur selon un premier mode de réalisation, monté sur une carte électronique du compteur ;
- la figure 3 est une vue en coupe selon un plan perpendiculaire à la carte électronique et en perspective du témoin selon le premier mode de réalisation et d'un premier support portant le témoin selon le premier mode de réalisation ;
- la figure 4 est vue en perspective du témoin selon le premier mode de réalisation sur lequel les aimants dont il est normalement équipé ont été retirés ;
- la figure 5 est une vue de dessous en perspective du témoin selon le premier mode de réalisation ;
- la figure 6 est une vue en perspective du premier support ;
- la figure 7 est une vue en perspective du témoin du compteur selon un deuxième mode de réalisation, le témoin selon le deuxième mode de réalisation étant positionné dans un boîtier plastique ;
- la figure 8 est une vue analogue à celle de la figure 7 dans laquelle le témoin selon le deuxième mode de réalisation étant situé à l'extérieur du boîtier plastique ;
- la figure 9 est une vue en coupe selon un plan perpendiculaire à la carte électronique et en perspective du témoin du compteur selon un troisième mode de réalisation et d'un troisième corps tournant dans lequel est positionné le témoin selon le troisième mode de réalisation ;
- la figure 10 représente le témoin selon le troisième mode de réalisation et le troisième corps tournant avant leur intégration ;
- la figure 11 représente le témoin selon le troisième mode de réalisation après qu'une tentative de fraude a été réalisée ;
- la figure 12 est une vue en coupe selon un plan perpendiculaire à la carte électronique et en perspective du témoin du compteur selon un quatrième mode de réalisation et d'un capot dans lequel est positionné le témoin selon le quatrième mode de réalisation ;
- la figure 13 représente le témoin selon le quatrième mode de réalisation et le capot avant leur intégration ;
- la figure 14 représente le témoin selon le quatrième mode de réalisation après qu'une tentative de fraude a été réalisée ;
- la figure 15 est une vue en perspective du témoin du compteur selon un cinquième mode de réalisation ;
- la figure 16 représente le témoin selon le cinquième mode de réalisation après qu'une tentative de fraude a été réalisée.

### DESCRIPTION DETAILLEE DE L'INVENTION

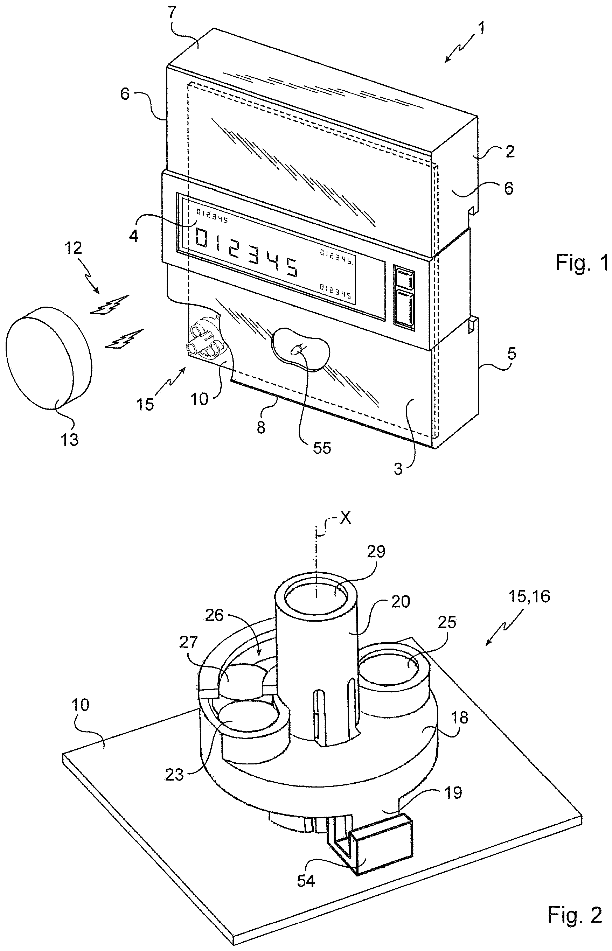

En référence à la figure 1, le compteur de l'invention est ici un compteur électrique électronique 1 destiné à mesurer une quantité d'énergie électrique consommée dans une habitation et à afficher cette mesure. Le compteur électrique est aussi adapté à réaliser un certain nombre de fonctions complémentaires : gestion des tarifs par réception d'ordres, relève et programmation à distance, télé-information client, etc.

Le compteur électrique 1 comporte un boîtier 2 de forme sensiblement parallélépipédique comprenant une face avant 3 munie d'un affichage LCD 4 permettant d'afficher les mesures de la quantité d'énergie électrique consommée par l'habitation, une face arrière 5 munie de moyens de fixation destinés à fixer le boîtier 2 à un mur de l'habitation, deux faces latérales 6, une face supérieure 7 et une face inférieure 8.

Le boîtier 2 contient une carte électronique 10 comportant un certain nombre de composants électroniques, et notamment des composants inductifs (transformateurs, inductances, etc.) utilisés dans des circuits d'alimentation de la carte électronique, de mesure de l'énergie électrique consommée, etc.

Ces composants inductifs présentent une valeur inductive qui s'effondre en présence d'un champ magnétique externe 12 généré par un aimant 13 lors d'une tentative de fraude.

Le boîtier 2 du compteur électrique 1 comporte un témoin 15 destiné à fournir une preuve irréfutable d'une telle tentative de fraude.

Dans un premier mode de réalisation, visible sur les figures 1 à 6, le témoin 15 est un tourniquet crénelé 16 ici monté sur la carte électronique 10 à proximité de la face inférieure 8 du boîtier 2 du compteur électrique 1. Le tourniquet crénelé 16 est porté par un premier support 17 et est monté tournant autour d'un axe X perpendiculaire à la carte électronique 10 et donc à la face avant 3 du boîtier 2.

En référence aux figures 2 à 4, le tourniquet crénelé 16 comporte une première base circulaire 18 perpendiculaire à l'axe X, un créneau 19 et une première partie tubulaire 20. Le créneau 19 et la première partie tubulaire 20 s'étendent perpendiculairement à la première base circulaire 18 de part et d'autre de la première base circulaire 18. Le créneau 19 est situé à la circonférence de la première base circulaire 18 alors que la première partie tubulaire 20 est située au centre de la base circulaire 18.

La première base circulaire 18 comporte un premier réceptacle d'accueil 22 destiné à accueillir un premier aimant fixe 23 et un deuxième réceptacle d'accueil 24 destiné à accueillir un deuxième aimant fixe 25, le premier réceptacle d'accueil 22 et le deuxième réceptacle d'accueil 24 étant positionnés symétriquement par rapport à un centre de la première base circulaire 18.

La première base circulaire 18 comporte de plus une glissière 26 s'étendant à l'intérieur de la première base circulaire 18 le long d'une partie de la circonférence de la première base circulaire 18 et destinée à accueillir un aimant mobile 27.

La première partie tubulaire 20 comporte quant à elle un troisième réceptacle d'accueil 28 destiné à accueillir un troisième aimant fixe 29, ledit troisième réceptacle d'accueil 28 étant situé au niveau d'une extrémité supérieure de la première partie tubulaire 20.

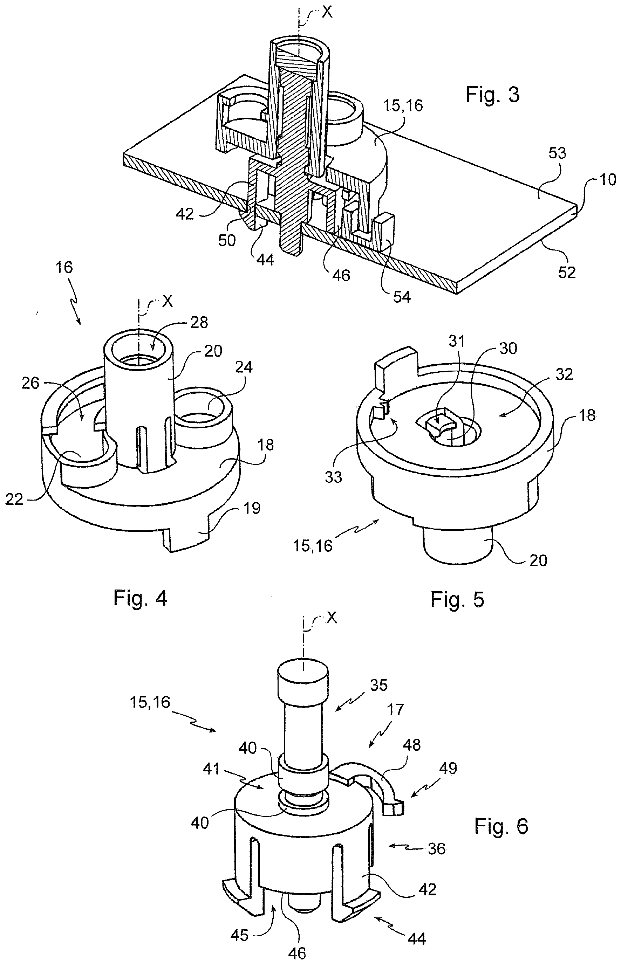

En référence à la figure 5, on note que le tourniquet crénelé 16 comporte un premier doigt flexible 30 s'étendant dans une partie inférieure de la première partie tubulaire 20, ledit premier doigt flexible 30 étant muni d'une première extrémité en redan 31 débouchant au niveau d'une partie inférieure 32 de la première base circulaire 18. On note aussi que le tourniquet crénelé 16 comporte une excroissance formant une première encoche 33 située sur une collerette circonférentielle s'étendant en saillie sous la partie inférieure de la première base circulaire 18.

En référence à la figure 6, le premier support 17 comporte, quant à lui, une colonne 35 d'axe X et un premier corps tubulaire 36.

La colonne 35 comporte sur sa longueur deux zones élargies 40 définissant une deuxième encoche 41.

Le premier corps tubulaire 36 comporte quant à lui une pluralité de bras flexible 42 qui s'étendent dans la longueur du premier corps tubulaire 36, chaque bras flexible 42 étant muni d'une deuxième extrémité en redan 44 située à une extrémité inférieure du premier corps tubulaire 36. Les bras flexibles 42 sont séparés par des encoches 45 ménagées dans le premier corps tubulaire 36 pour définir des surfaces d'appui 46 disposées sur une circonférence inférieure du premier corps tubulaire 36.

Enfin, le premier support 17 comporte un deuxième doigt flexible 48 comportant une troisième extrémité en redan 49. Le deuxième doigt flexible 48 est fixé au premier corps tubulaire 36 et s'étend à l'extérieur de celui-ci le long d'une partie d'une circonférence supérieure du premier corps tubulaire 36.

Le premier support 17 est monté sur la carte électronique 10 par insertion des bras flexibles 42 dans des ouvertures 50 pratiquées à cet effet dans la carte électronique 10. Le premier support 17 est maintenu en position par l'action simultanée des deuxièmes extrémités en redan 44 des bras flexibles 42 sur une face inférieure 52 de la carte électronique 10 et des surfaces d'appui 46 du premier corps tubulaire 36 sur une face supérieure 53 de la carte électronique 10.

Le tourniquet crénelé 16 est engagé sur le premier support 17 de sorte que la colonne 35 du premier support 17 s'étende à l'intérieur de la première partie tubulaire 20 du tourniquet crénelé 16 le long de celle-ci.

Le tourniquet crénelé 16 est ainsi monté tournant sur le premier support 17 autour de l'axe X de là colonne 35 du premier support 17.

On note qu'un capteur à fourche optique 54 est monté sur la carte électronique 10 et est positionné de manière à détecter la présence ou l'absence du créneau 19 du tourniquet crénelé 16 entre un émetteur et un récepteur du capteur à fourche optique 54.

On décrit maintenant le fonctionnement du témoin 15 selon le premier mode de réalisation.

Lorsqu'aucun champ magnétique important n'est généré à proximité du compteur électrique 1, le tourniquet crénelé 16 se trouve dans une position nominale angulaire prédéterminée et dans une position nominale longitudinale prédéterminée associées à l'absence d'une tentative de fraude. Ces positions nominales correspondent à la représentation du tourniquet crénelé 16 sur les figures 2 et 3.

Dans la position nominale angulaire, la troisième extrémité en redan 49 du deuxième doigt flexible 48 du premier corps tubulaire 36 du premier support 17 est positionnée dans la première encoche 33 de la première base circulaire 18 du tourniquet crénelé 16. La troisième extrémité en redan 49 et la première encoche 33 constituent un premier cliquet.

De même, dans la position nominale longitudinale, la première extrémité en redan 31 du premier doigt flexible 30 de la première partie tubulaire 20 du tourniquet crénelé 16 est positionnée dans la deuxième encoche 41 de la colonne 35 du premier support 17. La première extrémité en redan 31 et la deuxième encoche 41 constituent un deuxième cliquet.

Lorsque le tourniquet crénelé 16 se trouve dans la position nominale angulaire et dans la position nominale longitudinale, le capteur à fourche optique 54 détecte la présence du créneau 19 et peut donc transmettre une information selon laquelle le tourniquet crénelé 16 se trouve dans la position nominale angulaire et dans la position nominale longitudinale.

Le champ magnétique externe 12 généré à proximité du compteur électrique 1 par l'aimant 13 pour réaliser une tentative de fraude a pour effet d'entraîner en rotation le tourniquet crénelé 16 ou de déplacer longitudinalement le tourniquet crénelé 16 en l'éloignant du premier support 17.

L'entraînement en rotation du tourniquet crénelé 16 résulte de l'action du champ magnétique 12 sur le premier aimant fixe 23 et sur le deuxième aimant fixe 25. Le tourniquet crénelé 16 subit alors un déplacement angulaire et quitte la position nominale angulaire prédéterminée.

L'aimant mobile 27 permet d'éviter une situation dans laquelle l'aimant 13 génèrerait, du fait de sa position, des forces opposées sur le premier aimant fixe 23 et le deuxième aimant fixe 25 qui s'annuleraient et créeraient un état stable. L'aimant mobile 27 est ici initialement accolé au premier aimant fixe 23 par l'effet des champs magnétiques générés par le premier aimant fixe 23 et l'aimant mobile 27. L'action du champ magnétique externe 12 arrache l'aimant mobile 27 du premier aimant fixe 23 et déplace l'aimant mobile 27. L'énergie cinétique générée par ce déplacement entraîne en rotation le tourniquet crénelé 16 qui ne présente donc pas l'état stable redouté.

La troisième extrémité en redan 49 est alors libérée de la première encoche 33 et ne peut y être introduite à nouveau par une action externe au boîtier 2 du compteur électrique 1. Le premier cliquet constitue ainsi un dispositif anti-retour en rotation assurant l'irréversibilité du déplacement angulaire du témoin 15.

Le déplacement longitudinal du tourniquet crénelé 16 résulte de l'action du champ magnétique 12 sur le troisième aimant 29 de l'extrémité supérieure de la première partie tubulaire 20 du tourniquet crénelé 16. Le tourniquet crénelé 16 subit un déplacement longitudinal et quitte la position nominale longitudinale.

La première extrémité en redan 31 est alors libérée de la deuxième encoche 41 et ne peut y être introduite à nouveau par une action externe au boîtier 2 du compteur électrique 1. Le deuxième cliquet constitue ainsi un dispositif anti-retour en translation assurant l'irréversibilité du déplacement longitudinal du témoin 15.

Lorsque le tourniquet crénelé 16 quitte la position nominale angulaire et/ou la position nominale longitudinale, le capteur à fourche optique 54 détecte l'absence du créneau 19 et peut donc transmettre une information selon laquelle une tentative de fraude a été réalisée.

Cette information est ici transmise à un concentrateur de données externe au compteur électrique 1 via une transmission par courants porteurs en ligne.

Cette information est aussi transmise à des moyens de traitement de la carte électronique 10 qui allument et maintiennent une diode électroluminescente 55, montée sur la carte électronique 10, allumée lorsqu'une tentative de fraude est détectée. Cette diode électroluminescente 55 est de préférence invisible depuis l'extérieur du compteur électrique 1 pour qu'elle ne puisse pas aider le fraudeur dans sa tentative de fraude en lui fournissant une indication sur l'efficacité de sa tentative de fraude. Cette information peut aussi optionnellement être affichée sur l'écran LCD 4, bien qu'elle puisse dans ce cas aider le fraudeur dans sa tentative de fraude en lui fournissant une indication sur l'efficacité de sa tentative de fraude.

Ainsi, la tentative de fraude est détectée soit par un opérateur intervenant directement sur le compteur électrique 1 et constatant visuellement le déplacement irréversible du témoin 15 après ouverture du boîtier 2, soit par le même opérateur constatant que la diode électroluminescente 55 est allumée, soit par réception d'une information de fraude par le concentrateur de données externe, soit par affichage d'une information de tentative de fraude sur l'écran LCD 4.

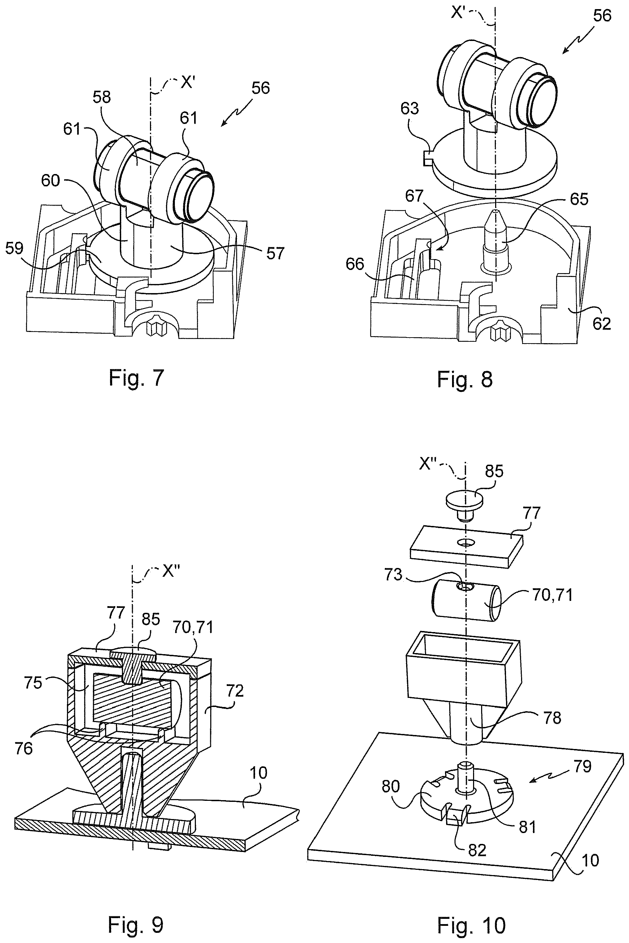

En référence aux figures 7 et 8, un témoin 56 selon un second mode de réalisation, qui ne fait pas partie de l'invention, est inséré dans un boîtier plastique 62 situé dans le boîtier 2 du compteur électrique 1, et est monté tournant autour d'un axe X' à nouveau perpendiculaire à la face avant 3 du boîtier 2 du compteur électrique 1.

Le témoin 56 comporte un premier corps tournant 57 et un premier noyau métallique 58 fixé sur le premier corps tournant 57.

Le premier corps tournant 57 comporte une deuxième base circulaire 59, un deuxième corps tubulaire 60 positionné au centre de la deuxième base circulaire 59, et deux pattes annulaires de fixation 61 qui s'étendent depuis une extrémité supérieure du deuxième corps tubulaire 60. Les deux pattes annulaires de fixation 61 sont d'axe perpendiculaire à celui du deuxième corps tubulaire 60.

La deuxième base circulaire 59 comporte un doigt radial 63 qui s'étend depuis la circonférence de la deuxième base circulaire 59 vers l'extérieur de la deuxième base circulaire 59.

Le premier noyau métallique 58 est de forme tubulaire. Le premier noyau métallique 58 est inséré dans les pattes annulaires de fixation 61 qui le maintiennent en position sur le premier corps tournant 57.

Le boîtier plastique 62, quant à lui, comporte une partie inférieure et une partie supérieure (non visible sur les figures). La partie inférieure du boîtier plastique 62 comporte un pion longitudinal 65 d'axe X' perpendiculaire à la face avant 3 du boîtier 2 et un troisième doigt flexible 66 comportant une extrémité munie d'une troisième encoche 67.

Le témoin 56 est positionné dans le boîtier plastique 62 de sorte que le pion longitudinal 65 s'étend à l'intérieur du deuxième corps tubulaire 60 du premier corps tournant 57, et est monté tournant dans le boîtier plastique 62 autour du pion longitudinal 65.

On décrit maintenant le fonctionnement du témoin 56 selon le deuxième mode de réalisation.

Lorsqu'aucun champ magnétique important n'est généré à proximité du compteur électrique 1, le premier corps tournant 57 du témoin 56 se trouve dans une position nominale angulaire prédéterminée correspondant à l'absence d'une tentative de fraude. Cette position nominale angulaire correspond à la représentation du témoin sur la figure 7.

Dans la position nominale angulaire, le doigt radial 63 de la deuxième base circulaire 59 du premier corps tournant 57 est positionné dans la troisième encoche 67 du troisième doigt flexible 66. Le doigt radial 63 et la troisième encoche 67 forment un troisième cliquet.

Un champ magnétique externe généré à proximité du compteur électrique 1 pour réaliser une tentative de fraude agit sur le premier noyau métallique 58 et a pour effet d'entraîner en rotation le premier corps tournant 57. Le premier corps tournant 57 subit alors un déplacement angulaire et quitte la position nominale angulaire prédéterminée.

Le doigt radial 63 est alors libéré de la troisième encoche 67 et ne peut y être introduit à nouveau par une action externe au boîtier 2 du compteur électrique 1. Le troisième cliquet constitue ainsi un dispositif anti-retour en rotation assurant l'irréversibilité du déplacement angulaire du témoin 56.

Ainsi, la tentative de fraude peut être détectée par un opérateur intervenant directement sur le compteur électrique 1 et constatant visuellement le déplacement irréversible du témoin 56 après ouverture du boîtier 2.

En référence aux figures 9 à 11, un témoin 70 selon un troisième mode de réalisation, qui ne fait pas partie de l'invention, est cette fois un deuxième noyau métallique 71 positionné dans un deuxième corps tournant 72.

Le deuxième noyau métallique 71 est de forme tubulaire et présente un trou aménagé 73 situé au milieu du deuxième noyau métallique 71.

Le deuxième corps tournant 72 est fabriqué en plastique transparent. Il comporte une cavité 75 munie d'un fond présentant deux nervures d'appui 76, un couvercle 77 en plastique transparent refermant la cavité 75, et une deuxième partie tubulaire 78.

Le deuxième corps tournant 72 est positionné sur un deuxième support 79 qui comporte une troisième base circulaire 80 et un deuxième pion longitudinal 81 d'axe X" perpendiculaire à la face avant 3 du boîtier 2 du compteur électrique 1, le deuxième pion longitudinal 81 étant situé au centre de la troisième base circulaire 80.

La troisième base circulaire 80 est fixée à la carte électronique 10 via trois clips 82 positionnés à 120° sur la circonférence de la troisième base circulaire 80.

Le deuxième corps tournant 72 est positionné sur le deuxième support 79 de sorte que le deuxième pion longitudinal 81 s'étend à l'intérieur de la deuxième partie tubulaire 78 du deuxième corps tournant 72. Le deuxième corps tournant 72 est monté tournant autour du deuxième pion longitudinal 81.

En position nominale, visible sur la figure 9, le deuxième noyau métallique 71 est positionné et centré par centrage long sur les nervures d'appui 76. Il est maintenu dans cette position nominale par l'effet de frottements exercés par des faces de la cavité 75 du deuxième corps tournant 72.

Lors du transport du compteur électrique 1, un pion de centrage 85 est maintenu en position au travers du couvercle 77 dans le trou aménagé 73 du deuxième noyau métallique 71 pour assurer la stabilité de la position du deuxième noyau métallique 71 lors du transport. Le pion de centrage 85 est retiré au moment de l'installation du compteur électrique 1 par un professionnel en charge de l'installation dudit compteur électrique 1. On note que le deuxième corps tournant 72 et le pion de centrage 85 sont inaccessibles pour l'abonné, et qu'une fois que le pion de centrage 85 a été déboité ou retiré, il ne peut être remis en place sur le deuxième corps tournant 72.

On décrit maintenant le fonctionnement du témoin 70 selon le troisième mode de réalisation.

Lorsqu'aucun champ magnétique important n'est généré à proximité du compteur électrique 1, le deuxième noyau métallique 71 se trouve dans la position nominale évoquée ci-dessus.

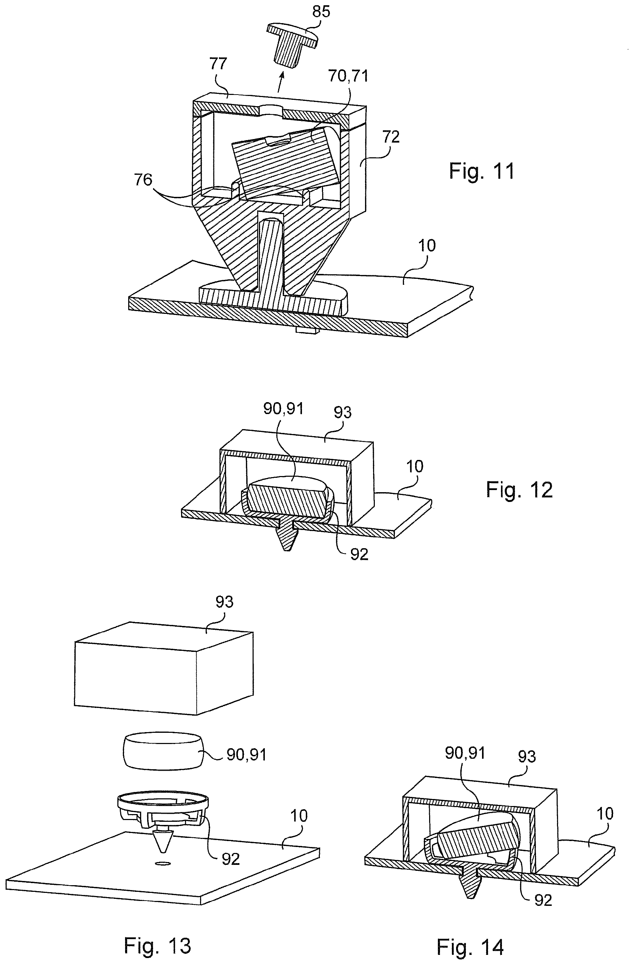

Un champ magnétique externe généré à proximité du compteur électrique 1 pour réaliser une tentative de fraude agit sur le deuxième noyau métallique 71 et a pour effet d'entraîner en rotation le deuxième corps tournant 72 et de coller le deuxième noyau métallique 71 à une face de la cavité 75 la plus proche de l'aimant 13. Comme cela est visible sur la figure 11, le deuxième noyau métallique 71 se positionne en biais entre les deux nervures d'appui 76 et ne peut pas retrouver sa position nominale par une action externe au boîtier 2 du compteur électrique 1.

Ainsi, grâce au fait que le deuxième corps tournant 72 et le couvercle 77 sont fabriqués en plastique transparent, la tentative de fraude peut être est détectée par un opérateur intervenant directement sur le compteur électrique 1 et constatant visuellement le déplacement irréversible du témoin après ouverture du boîtier 2.

En référence aux figures 12 à 14, un témoin 90 selon un quatrième mode de réalisation, qui ne fait pas partie de l'invention, est cette fois un troisième noyau métallique 91.

En position nominale, le troisième noyau métallique 91 est monté en force dans un support en élastomère 92.

Le support en élastomère 92 est quant à lui clipsé sur la carte électronique 10.

Le support en élastomère 92 et le troisième noyau métallique 91 sont positionnés à l'intérieur d'un capot transparent 93.

Lorsqu'aucun champ magnétique important n'est généré à proximité du compteur électrique 1, le troisième noyau métallique 91 se trouve dans la position nominale évoquée ci-dessus.

Un champ magnétique externe généré à proximité du compteur électrique 1 pour réaliser une tentative de fraude agit sur le troisième noyau métallique 91 et a pour effet d'expulser le troisième noyau métallique 91 du support en élastomère 92. Le troisième noyau métallique 91 demeure à l'intérieur du capot 93 après son expulsion du support en élastomère 92 et ne peut pas retrouver sa position nominale par une action externe au boîtier 2 du compteur électrique 1.

Ainsi, grâce au fait que le capot 93 est transparent, la tentative de fraude peut être est détectée par un opérateur intervenant directement sur le compteur électrique 1 et constatant visuellement le déplacement irréversible du témoin après ouverture du boîtier 2.

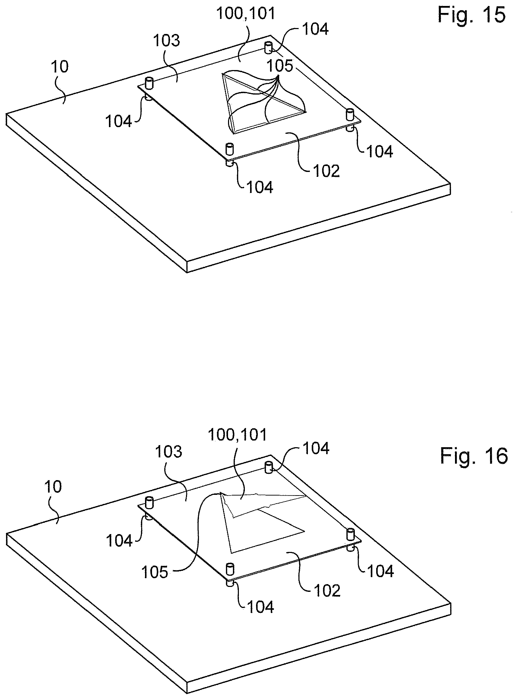

En référence aux figures 15 et 16, un témoin 100 est constitué par une première partie magnétisable 101 d'une feuille 102 qui comprend une deuxième partie fixe 103.

La première partie magnétisable 101 est ici une partie triangulaire de la feuille 102 et la deuxième partie fixe 103 est constituée par le reste de la feuille 102. La feuille 102 est fixée sur la carte électronique 10 par quatre entretoises 104.

La première partie magnétisable 101 est partiellement prédécoupée de la feuille 102, de sorte qu'elle n'est maintenue à celle-ci que grâce à quelques points de fixation 105 positionnés au niveau des centres et des sommets du triangle délimitant la première partie magnétisable 101.

La position nominale du témoin 100, visible sur la figure 14 correspond à une position dans laquelle la première partie magnétisable 101 est fixée à la deuxième partie fixe 103 de la feuille 102 par l'ensemble des points de fixation 105.

Un champ magnétique externe généré à proximité du compteur électrique 1 pour réaliser une tentative de fraude agit sur la première partie magnétisable 101 et a pour effet de déchirer la première partie magnétisable 101 au moins partiellement de la feuille 102.

La première partie magnétisable 101 ne peut pas retrouver sa position nominale par une action externe au boîtier 2 du compteur électrique 1.

Ainsi, la tentative de fraude peut être est détectée par un opérateur intervenant directement sur le compteur électrique 1 et constatant visuellement, après ouverture du boîtier 2, le déchirement irréversible de la première partie magnétisable 101 de la feuille 102.

L'invention n'est pas limitée aux modes de mise en œuvre particuliers qui viennent d'être décrits, mais, bien au contraire, couvre toute variante entrant dans le cadre de l'invention telle que définie par les revendications.

Bien que l'on ait indiqué que le capteur utilisé pour détecter la présence ou non du créneau 19 du tourniquet crénelé 16 et donc pour détecter qu'une tentative de fraude a ou non été réalisée est un capteur optique, il est possible d'utiliser un autre type de capteur pour détecter le déplacement irréversible du témoin : capteur magnétique, etc.

Bien que l'on ait indiqué que l'information relative à la tentative de fraude est transmise à un concentrateur de données externe par une transmission par Courants Porteurs en Ligne, cette information peut parfaitement être transmise à un autre type d'organe externe (système d'information, etc.) par un autre type de communication (transmission sans fil, etc.).

Bien que l'on ait utilisé soit un aimant soit un noyau métallique selon les modes de réalisation du témoin présentés, il est parfaitement possible de remplacer ces noyaux métalliques ou aimants par d'autres types d'éléments magnétisables.

Bien que l'on ait indiqué que certains témoins selon certains modes de réalisation présentés sont montés sur une carte électronique, il est parfaitement possible de les monter sur la mécanique du boîtier.

## Revendications

1. Compteur de type compteur électrique comportant un boîtier (2) dans lequel est intégré au moins un composant dont le fonctionnement est susceptible d'être perturbé par un champ magnétique (12) externe généré par exemple par un aimant (13) pour réaliser une tentative de fraude, le compteur comportant un témoin (15 ; 56 ; 70 ; 90 ; 100) qui est monté dans le compteur dans une position prédéterminée et qui comprend un élément magnétisable (23, 25, 27, 29 ; 58 ; 71 ; 91 ; 101) sous l'effet du champ magnétique, de telle manière que le témoin soit déplaçable de manière irréversible lorsque le champ magnétique est généré permettant ainsi de révéler la tentative de fraude, le témoin (15 ; 56) étant monté tournant dans le boîtier (2) autour d'un axe (X) et étant entraîné en rotation sous l'effet du champ magnétique de sorte que la tentative de fraude peut être constatée par détection d'un déplacement angulaire irréversible du témoin ; le compteur étant **caractérisé en ce que** le témoin est un tourniquet crénelé (16) comportant une base perpendiculaire (18) à l'axe (X) sur laquelle sont positionnés l'élément magnétisable et au moins un créneau (19) s'étendant perpendiculairement à la base, le déplacement angulaire du témoin étant détecté par détection d'un déplacement angulaire du créneau.

2. Compteur selon la revendication 1, dans lequel le témoin (15) est en outre déplaçable longitudinalement selon l'axe (X), de sorte que la tentative de fraude peut aussi être détectée par détection d'un déplacement longitudinal irréversible du témoin.

3. Compteur selon la revendication 1, dans lequel l'axe (X) est un axe perpendiculaire à une face avant du boîtier (2).

4. Compteur selon la revendication 1, dans lequel le témoin comporte un élément magnétisable fixe (23, 25, 29) et un élément magnétisable (27) monté mobile sur la base du tourniquet (16).

5. Compteur selon la revendication 4, dans lequel le deuxième élément magnétisable est positionné dans une glissière (26) située sur la base du tourniquet.

6. Compteur selon la revendication 1, dans lequel l'irréversibilité du déplacement angulaire du témoin est assurée par un dispositif anti-retour en rotation comportant un premier cliquet.

7. Compteur selon la revendication 2, dans lequel l'irréversibilité du déplacement longitudinal du témoin est assurée par un dispositif anti-retour en translation comportant un deuxième cliquet.

8. Compteur selon l'une des revendications précédentes, dans lequel l'élément magnétisable est un aimant.

9. Compteur selon l'une des revendications précédentes, dans lequel l'élément magnétisable est un noyau métallique.

10. Compteur selon l'une des revendications précédentes, dans lequel le déplacement irréversible du témoin est détecté par un capteur (54).

11. Compteur selon la revendication 10, dans lequel le capteur est un capteur magnétique.

12. Compteur selon la revendication 10, dans lequel le capteur est un capteur optique.

## Patentansprüche

1. Zähler vom Typ Stromzähler, umfassend ein Gehäuse (2), in dem mindestens ein Bauelement integriert ist, dessen Betrieb möglicherweise von einem äußeren Magnetfeld (12), das beispielsweise von einem Magneten (13) erzeugt wird, gestört werden kann, um einen Betrugsversuch durchzuführen, wobei der Zähler eine Anzeigevorrichtung (15; 56; 70; 90; 100) umfasst, die in dem Zähler in einer vorbestimmten Position angebracht ist und ein unter der Wirkung des Magnetfeldes magnetisierbares Element (23, 25, 27, 29; 58; 71; 91; 101) umfasst, derart, dass die Anzeigevorrichtung auf irreversible Weise verschiebbar ist, wenn das Magnetfeld erzeugt wird, wodurch der Betrugsversuch aufgedeckt werden kann, wobei die Anzeigevorrichtung (15; 56) in dem Gehäuse (2) drehbar um eine Achse (X) gelagert ist und unter der Wirkung des Magnetfelds in Drehung angetrieben wird, sodass der Betrugsversuch durch Erfassen einer irreversiblen Winkelverschiebung der Anzeigevorrichtung festgestellt werden kann; wobei der Zähler **dadurch gekennzeichnet ist, dass** die Anzeigevorrichtung ein gezacktes Drehkreuz (16) ist, das eine sich senkrecht zur Achse (X) erstreckende Basis (18) umfasst, auf der das magnetisierbare Element und mindestens eine Zinne (19) positioniert sind, die sich senkrecht zur Basis erstreckt, wobei die Winkelverschiebung der Anzeigevorrichtung durch Erfassen einer Winkelverschiebung der Zinne erfasst wird.

2. Zähler nach Anspruch 1, bei dem die Anzeigevorrichtung (15) ferner entlang der Achse (X) in Längsrichtung verschiebbar ist, sodass der Betrugsversuch auch durch Erfassen einer irreversiblen Längsverschiebung der Anzeigevorrichtung erfasst werden kann.

3. Zähler nach Anspruch 1, bei dem die Achse (X) eine Achse ist, die senkrecht zu einer Vorderfläche des Gehäuses (2) ist.

4. Zähler nach Anspruch 1, bei dem die Anzeigevorrichtung ein ortsfestes magnetisierbares Element (23, 25, 29) und ein an der Basis des Drehkreuzes (16) beweglich gelagertes magnetisierbares Element (27) umfasst.

5. Zähler nach Anspruch 4, bei dem das zweite magnetisierbare Element in einer Gleitschiene (26) positioniert ist, die sich auf der Basis des Drehkreuzes befindet.

6. Zähler nach Anspruch 1, bei dem die Unumkehrbarkeit der Winkelverschiebung der Anzeigevorrichtung von einer Drehsperrvorrichtung sichergestellt wird, die eine erste Sperrklinke umfasst.

7. Zähler nach Anspruch 2, bei dem die Unumkehrbarkeit der Längsverschiebung der Anzeigevorrichtung von einer Translationssperrvorrichtung sichergestellt wird, die eine zweite Sperrklinke umfasst.

8. Zähler nach einem der vorhergehenden Ansprüche, bei dem das magnetisierbare Element ein Magnet ist.

9. Zähler nach einem der vorhergehenden Ansprüche, bei dem das magnetisierbare Element ein Metallkern ist.

10. Zähler nach einem der vorhergehenden Ansprüche, bei dem die irreversible Verschiebung der Anzeigevorrichtung von einem Sensor (54) erfasst wird.

11. Zähler nach Anspruch 10, bei dem der Sensor ein Magnetsensor ist.

12. Zähler nach Anspruch 10, bei dem der Sensor ein optischer Sensor ist.

## Claims

1. Meter of the electricity meter type comprising a housing (2) in which at least one component is integrated, the functioning of which component can be disrupted by an external magnetic field (12) generated, for example, by a magnet (13) for the purpose of a fraud attempt, the meter comprising an indicator (15; 56; 70; 90; 100) that is mounted in the meter in a predetermined position and that comprises an element (23, 25, 27, 29; 58; 71; 91; 101) that can be magnetised under the influence of the magnetic field such that the indicator can be displaced in an irreversible manner when the magnetic field is generated, thus making it possible to reveal the fraud attempt, the indicator (15; 56) being mounted so as to rotate in the housing (2) about an axis (X) and being rotated under the influence of the magnetic field such that the fraud attempt can be identified by detecting an irreversible angular displacement of the indicator; the meter being **characterised in that** the indicator is a crenellated carousel (16) comprising a base (18) perpendicular to the axis (X), on which base the magnetisable element and at least one tab (19) extending perpendicularly to the base are positioned, the angular displacement of the indicator being detected by detecting an angular displacement of the tab.

2. Meter according to claim 1, wherein the indicator (15) can also be displaced longitudinally along the axis (X) such that the fraud attempt can also be detected by detecting an irreversible longitudinal displacement of the indicator.

3. Meter according to claim 1, wherein the axis (X) is an axis that is perpendicular to a front face of the housing (2).

4. Meter according to claim 1, wherein the indicator comprises a fixed magnetisable element (23, 25, 29) and a magnetisable element (27) that is mounted so as to be able to move on the base of the carousel (16).

5. Meter according to claim 4, wherein the second magnetisable element is positioned in a slide (26) on the base of the carousel.

6. Meter according to claim 1, wherein the irreversibility of the angular displacement of the indicator is ensured by means of a device for preventing rotational return comprising a first catch.

7. Meter according to claim 2, wherein the irreversibility of the longitudinal displacement of the indicator is ensured by means of a device for preventing translational return comprising a second catch.

8. Meter according to any of the preceding claims, wherein the magnetisable element is a magnet.

9. Meter according any of the preceding claims, wherein the magnetisable element is a metal core.

10. Meter according to any of the preceding claims, wherein the irreversible displacement of the indicator is detected by means of a sensor (54).

11. Meter according to claim 10, wherein the sensor is a magnetic sensor.

12. Meter according to claim 10, wherein the sensor is an optical sensor.
